Europäisches Patentamt

European Patent Office

Office européen des brevets

(11) Publication number: **0 492 302 A2**

## EUROPEAN PATENT APPLICATION

(21) Application number: **91121335.3**

(22) Date of filing: **12.12.91**

(51) Int. Cl.⁵: **H01P 1/20**

(30) Priority: **28.12.90 IT 2255890**

(43) Date of publication of application:
**01.07.92 Bulletin 92/27**

(84) Designated Contracting States:
**BE CH DE DK ES FR GB LI NL SE**

(71) Applicant: **FOR.E.M. S.p.A.**
**Via Archimede 22/24**
**I-20041 Agrate Brianza (Milano)(IT)**

(72) Inventor: **Cavalieri D'Oro, Enzo**
**Via Lecco 88**
**I-20052 Monza(IT)**
Inventor: **Bandera, Mario**
**Via Garibaldi 4**
**I-20040 Carnate(IT)**

(74) Representative: **Incollingo, Italo**
**Piazzale Lavater, 3**
**I-20129 Milano(IT)**

(54) **System for filtering signals of high and low frequency bands, relevant implementation device.**

(57) A filtering system for separating two signals included in different frequency bands, in which the composite signal S1 + S2 to be separated is input into an inductive element (LH) belonging to the high frequency filter section, in which element therefore the high frequency signal S1 and also the low frequency signal pass; said signal S1 is immediately coupled by means of mutual induction with a resonant element of said first filter section, said resonant element being made-up so that the low frequency signal S2 cannot be coupled with itself becouse of the low value of its frequency; then said sole signal S2 is transmitted towards the low pass filter section acting as rejection section of the high frequency band, which therefore has been introduced into the resonator and separated without passing or interesting the low frequency filter section and without suffering the deterioration caused by its passage into said low frequency filter section.

The present invention refers to a filtering system for separating e.g. two signals or bands of different frequencies, one of the bands to be separated having frequencies (e.g. from that of the D.C. to hundreds of MHz) relatively lower than the frequeNcies of the other high frequency band, e.g. from 800 MHz to 20 GHz.

The invention includes also the relevant circuit and, in an advantageous and critical embodiment, the installation of this circuit on a wall of a resonant cavity.

## Statement of the Prior Art

Usually in the telecommunication field it is convenient to transmit contemporaneously, e.g. on a same carrier means, such as a cable, two or more signal types, e.g. a high frequency signal that must pass through a pass-band filter and a low frequency signal, that can include also the D.C..

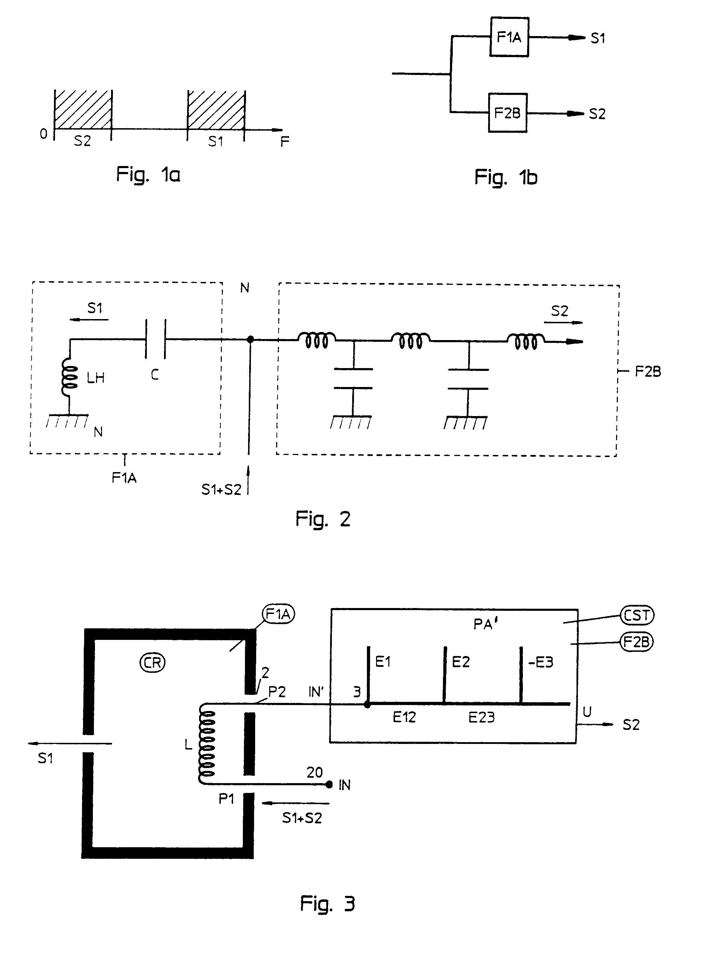

For fixing better the ideas, the Figure 1a shows the frequency bands e.g. S2 from 0 to about 300 MHz, and S1 e.g. from 925 to 970 MHz.

The Figure 1b represents a block scheme of a conventional circuit, in which the composite signal S1 + S2 is applied on two filters connected in parallel F1A (that allows the sole band S1 to pass), respectively F2B that allows the sole band S2 to pass.

The technical literature indicates many possible circuits allowing to solve this problem. In any case they are not exempt from drawbacks, in particular arising from losses, damages of the bands,especially the high frequency bands, overall dimensions, costs, etc..

The circuit scheme of Figure 1b can assume, in the more emblematic known Art, specially in the hypothesis that is almost always verified when it is used a low-pass filter F2B with inductive input, the configuration of Figure 2 in which S1 + S2 is applied on the node N that has at its left side F1A including substantially a high capacitor C followed by an inductance LH (joined to earth) and at its right side F2B including the inductances L1b, L2b, L3b connected in series and capacities C1b, C2b, etc. etc. connected in parallel towards earth.

The condenser C has the aim of preventing that the D.C. and low frequencies of S2 are shortcircuited towards earth through the input coupling bobbin of passband filter F1A.

The pass-band filter F2B located upstream C allows the transit of the D.C. and low frequencies.

Even if the described circuit can solve the "overall dimensions" problem, it has many drawbacks among which we can mention:

- high input capacity, caused by the sum of C with the capacities C1b, C2b, etc. of the low-pass filter F2B;

- high insertion loss in the high frequency band S1 caused by the fact that the low-pass filter F2B is upstream, i.e. is it precedes the pass-band filter F1A;

- the capacity inserted in series with the input inductance LH of low-pass filter F1A causes a resonance that creates a dangerous attenuation in a band near to the used bands.

## Summary of the invention

The first scope of the invention is to provide a filtering system that solves in the best manner the above mentioned problem eliminating the drawbacks shown by the circuits of Prior Art. Another scope of the invention is to provide a filter structure (printed circuit filter) that has the main characteristics of:

- minimum energy loss for both signals S1 and S2;

- minimum capacity measured at the circuit input;

- minimum overall dimensions;

- minimum cost.

These and other scopes are obtained by the filter system, that is characterized in that it includes:

- an inductance L acting as input element of the pass-band filter through which the high frequency signal S1 and also the low frequency signal S2 pass;

- at least a resonant cavity or resonator CR, in which said inductance is inserted;

- the characteristics of said inductance L and cavity CR being suitable for carrying out a reciprocal optimal coupling with the high frequency signal S1 by mutual induction, and practically no coupling with the low frequency signal S2;

- a low-pass filter section F2B for said signal S2, including now a printed circuit CST external to the cavity CR, formed by stubs and connection tracks having lengths preferably equal to one fourth of wave length of signal S1;

- this last signal S1 being now filtered as first signal and not circulating in the low-pass filter section, from whose possible negative influences S1 is now immunized.

Other characteristics of the system as well as of the relevant implementation filter structures are recited in the annexed claims.

## Description of Drawings and Embodiments

The different features and advantages of the invention shall appear better from the description of the preferred (and not limitative) embodiments represented in annexed drawings, in which:
- Figure 3 is an equivalent scheme of the filtering system according to the invention;
- Figure 4 is a partial section view made with a cross plane of a practical embodiment of the composite filter according to the invention and of its optimal installation in a part of the wall PA of the cavity CR;
- Figure 4A is a partial section view of Figure 4;
- Figure 5 is a partial section view, similar to the section of Figure 4A, but in enlarged scale, limitedly to the niche NI formed in the wall PA of the cavity CR1, in which the printed circuit CST closed by a proper protection cover COP is inserted; and
- Figure 5A is a front view, also this in enlarged scale, of the sole printed circuit.

The figures indicate the equal elements with equal reference numbers.

The Figure 3 shows the equivalent scheme of the filter according to the invention and includes now an input IN of the composite signal S1 + S2 entering an inductance L that is inserted in a cavity resonator CR. The assembly of L and CR form the high frequency filter section f1a, while the low frequency section f2b includes a printed circuit cst, including the true plate pa', on which there are printed n stubs, e.g. E1, E2 and E3 connected with one another by the tracks E12, E23, etc.. The output of S2 is indicated by U.

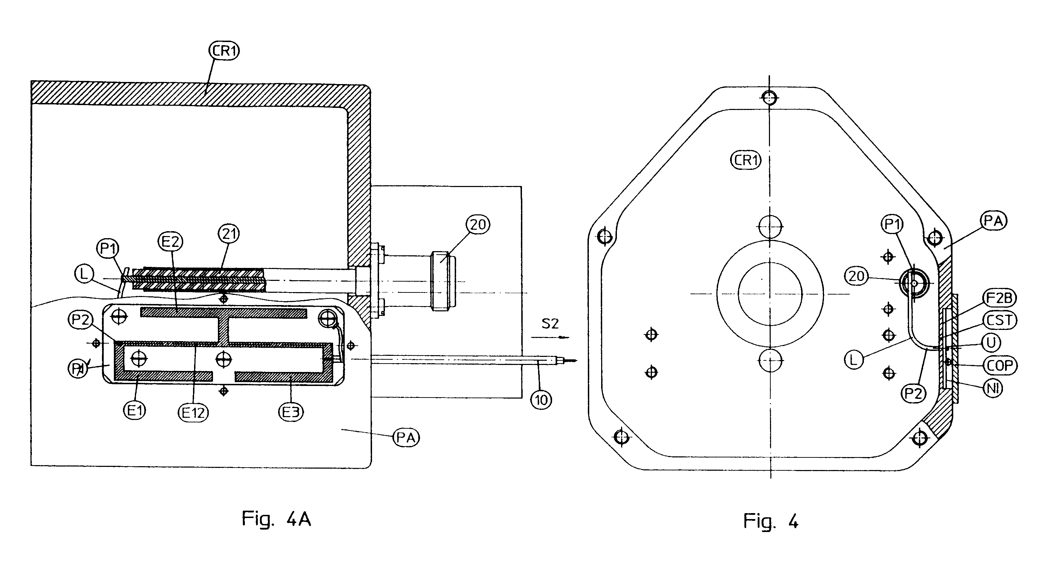

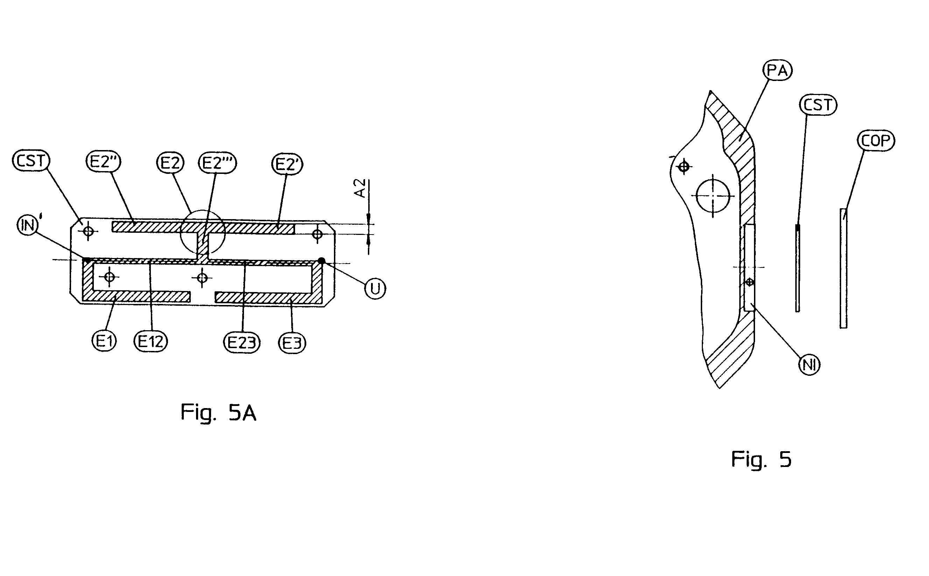

Generally speaking the cavity CR1 is the first resonator of filter F1A through which the signal S1 passes and can indifferently be of coaxial type, in wave guide form, or a dielectric resonator; important is that its input is inductive, that is formed by a bobbin L, whose first end P1 is connected to the input connector 20 (Figures 4 and 4A) and whose second end P2 is joined to the input IN' in Figure 5A) of the filter F2B, through which the sole low frequency signal S2 passes.

As above said the inductance L represents now the input element of the pass-band filter F1A through which the high frequency signal S1 passes. Also the low frequency signal S2 passes through L, but while S1 is coupled by mutual induction with the first resonator CR1 of the filter F1A, S2 cannot be coupled with said CR1 owing to the low value of its frequency and goes on towards the band-rejection filter F2B. For getting an optimal coupling of S1 with F1A it is necessary that the second end head P2 of L be electrically connected to the earth of the filter F1A. This is obtained preferably by means of the first stub E1 of the filter F2B, that, as above said, is formed by two or more stubs E1, E2, E3....., which have characteristically a length of one fourth of the wave length of signal S1, are closed on open circuit at their second ends and are separated by sections of line E12, E23... having a high impedance and also as long as one fourth of the wave length of the signal S1.

The mean skilled technician can understand easily that, in an equivalent manner, the stub E1, owing to its electric length, has an electric short circuit in P2 and that the filter F2B highly attenuates the frequency band of the signal S1 without disturbing the signal S2, that can pass without obstacles.

In the embodiment of Figures 4, 4A, 5 and 5A the filter F2B is of the band-rejection type, but it can also be of low-pass type.

In said embodiment particularly advantageous as concerns cost, reliability, losses and overall dimensions, the filter F2B, made-up by a printed circuit CST, on the board of which are applied the stubs E1, E2, E3... En and the connection elements E12 and E23, and which CST is housed in a niche Ni formed externally in a wall PA of the cavity CR1 and is shielded from outside by a cover COP e.g. screwed to the wall PA.

The inductance L goes out of the cavity CR1 passing through a hole made in the same cavity and is welded to the printed circuit CST, e.g. at the base of the first stub E1.

The printed circuit CST is fixed by means of screws to the wall of the cavity CR1, this wall shielding the same printed circuit from the electromagnetic fields existing in the inside of CR1, avoiding unwished couplings.

Finally the printed circuit is joined to a coaxial cable 10, that forms the output U of the low frequency signal S2.

In an alternative embodiment the printed circuit might be housed in the inside of the cavity CR1, but in this case it should be necessary to add a shield for avoiding unwished couplings between the printed circuit and the electromagnetic fields existing in the cavity CR1.

The device can run also without shield, but probably with degraded characteristics.

In all preceding embodiments the filter F2B is located downstream the inductance L, by which the high frequency signal S1 is coupled to the filter F1A. This allows to eliminate the capacitor C of the known technics (Figure 2), therefore it is reduced the circuit capacity. Further the position occupied by the filter F2B and the absence of the capacity C reduce the energy loss suffered by the high frequency signal S1. The Figure 5A represents the printed circuit CST in enlarged scale for allowing a better comprehension of the disposition of stubs (E1, E2, E3) and connection tracks E12, E23, that can also be different from the simple represented solution. For example E2 was represented as made-up symmetrically by the pieces E2', E2'', E2''', e.g. having the thickness A2.

The different pieces can have different configurations, and further some thereof can be also eliminated; e.g. E2'' can be eliminated and consequently the thickness A2 of E2' can be increased. IN' indicates the input in F2B and U the output by the cable 10. IN' is also the point in which it occurs a type of short circuit for S1 that is made easier owing to its total coupling with the first resonator CR1. The Figure 5 shows an exploded view of the niche NI formed in the wall PA of CR1, in which it must be installed the printed circuit CST, that on its turn is protected by the external cover COP.

As it was specified, among the advantages obtained by the system according to the invention it must be underlined in particular the elimination of the capacity C of known Art, in particular the elimination of the capacity from the high frequency filter; the system capacity now present only in F2B is reduced to the distributed capacities that e.g. of the tracks E12, E13 show versus earth; the disposition of F2B downstream F1A, causing the high frequency signal not to cross F2B and not to suffer eventual damages; the embodiment of F2B in a printed circuit form (low cost) and its installation in a niche formed in the wall of CR1 (notable reduction of dimensions).

In this manner a high and surprising optimization of the characteristics is reached, in particular a contemporaneous "maximum maximorum" value in the reductions of losses, costs and overall dimensions. These advantages become really critical and can be better appreciated if it is made reference to the embodiment of the tuning devices and band couplers for telecommunication circuits in mobile apparatus. Indeed in these devices the tuning of resonators on wide bands is very important and was solved using a cavity of the type CR1 that can be tuned by means of a female dielectric coupled with a male dielectric; the relative cavity with double dielectrics forms the object of a first patent application, while the object of a second patent application (also this contemporaneous to the first and to this application) is formed by the sagacious configurations of each cavity (in bottle form), and disposition of many cavities with one another (the first turned of 180° with respect to the other one).

The descriptions of the two above mentioned contemporaneous patent applications can be considered as an integral part of this description and therefore here incorporated, as they contribute greatly to a better appreciation of the invention, that forms the object of this patent application.

**Claims**

1. A filtering system for separating two signals included in different frequency bands, one of these signals to be separated being included in a low frequency band (S2) that can extend e.g. from the direct current until 300 MHz and that is filtered in a first section of pass-band filter (F2B), the second signal being included in a higher frequency band (S1) e.g. from 600 MHz to 15 GHz and being separated in a second filter section F1A,
characterized in that:
the composite signal S1 + S2 to be separated is input into an inductive element (LH) belonging to the high frequency filter section, in which element therefore the high frequency signal S1 and also the low frequency signal pass; said signal S1 is immediately coupled by means of mutual induction with a resonant element of the first filter section, said resonant element being made-up so that the low frequency signal S2 cannot be coupled therewith owing to the low value of its frequency; then the said sole signal S2 is transmitted towards the low pass filter acting therefore as rejection section of the high frequency band, which has been introduced into the resonator and separated without passing or interesting the low frequency filter section and therefore without suffering the deterioration caused by its passage into said low frequency filter section.

2. The system according to claim 1, characterized in that the impedance of the low frequency filter section has very low, and even negligible capacitive component, the high frequency section capacity being substantially eliminated.

3. The system according to claim 1 or 2, characterized in that the coupling by mutual induction between the high frequency signal S1 and the resonator element is carried out by inserting in the inside of this last resonator the input induction element, which is the sole path of the combined signal S1 + S2.

4. The system according to claim 3, characterized in that for optimizing the coupling by mutual induction of S1 travelling along the input induction element of S1 + S2 which penetrates into the resonator element, the second end (P2) of L is connected to the earth of the first filter section F1A by means of at least a member (e.g. E1) of the second filter section F2B.

5. The system according to claim 4, characterized in that said element E1 of F2B has a length equal to one fourth of the wave length of S1.

6. A composite filter system according to preceding claims, and including two sections, the first being a high frequency pass-band filter F1A and the second being a low frequency pass-band filter F2B, characterized by:

   - an input inductance (L) for the composite signal, a resonant cavity, magnetically coupled with the inductance, a printed circuit and, applied on this last printed circuit, an engraved circuit made up of many stubs having a length of one fourth of the wave length of the high frequency signal, which stubs are joined to the second end of said inductance electrically connected to earth, bringing to the earth said cavity.

7. The composite filter according to preceding claim, characterized in that said stubs are made as an open circuit at the end opposite to the inductance and are joined with one another by high impedance track sections (E12, E23), also these last sections having a length equal to one fourth of the wave length of the high frequency signal (S1).

8. The filter according to claim 6 or 7, characterized in that the first high frequency pass-band filter section formed by the cavity and input inductance of the total signal is located upstream the low-pass section including the printed circuit with stubs joined by tracks, the high frequency signal being picked up by said first section (F1A) and not crossing the section downstream F2B.

9. The filter according to one or more of the claims from 6 to 8, characterized in that the printed circuit (section F2B) is assembled in a niche formed in a part of the cavity wall.

10. The filter according to claim 9, characterized in that the inductance is formed by a coil welded with its second terminal crossing the cavity wall, to a stub of the printed circuit and with its first terminal to the end of a coaxial cable which carries the signal and penetrates in the inside of the cavity by means of the central part of a cavity wall laying in a plane orthogonal to the plane of the wall, in which it is formed the niche that after the insertion of the printed circuit is closed by a cover.

EP 0 492 302 A2

Fig. 1a

Fig. 1b

Fig. 2

Fig. 3

Fig. 4A

Fig. 4

Fig. 5A

Fig. 5

A2